# EUROPÄISCHE PATENTANMELDUNG

(11) **EP 4 345 898 A2**
(43) Veröffentlichungstag der Anmeldung: **03.04.2024**
(21) Anmeldenummer: 23199644.8
(22) Anmeldetag: 26.09.2023
(51) Int. Cl.: H01L 25/07, H01L 23/498

(54) **HALBBRÜCKEN-LEISTUNGSVORRICHTUNG UND HALBBRÜCKEN-LEISTUNGSMODUL**

(30) Priorität: 28.09.2022 CN 202222577641 U
(71) Anmelder: ZF Friedrichshafen AG, 88046 Friedrichshafen (DE)
(72) Erfinder: HU, Zhiwu, Shanghai (CN); DONG, Tianyuan, Shanghai (CN); LI, Zhao, Shanghai (CN)

(57) **Zusammenfassung**

In der vorliegenden Anmeldung werden eine Halbbrücken-Leistungsvorrichtung und ein Halbbrücken-Leistungsmodul bereitgestellt. Die Halbbrücken-Leistungsvorrichtung umfasst: ein Modulsubstrat, das eine obere Oberfläche mit einer Kupferbeschichtung aufweist, wobei die Kupferbeschichtung diskret einen ersten Halbbrückenbereich, einen zweiten Halbbrückenbereich, einen ersten Halbbrückenabführbereich und einen zweiten Halbbrückenabführbereich umfasst. Dabei befinden sich der erste Halbbrückenabführbereich und der zweite Halbbrückenabführbereich jeweils an beiden Enden des Modulsubstrats. Ein erster Halbbrücken-Leistungschip und ein zweiter Halbbrücken-Leistungschip liegen jeweils an dem ersten Halbbrückenbereich und dem zweiten Halbbrückenbereich an. Eine erste Leistungsanschlussklemme, eine zweite Leistungsanschlussklemme und eine dritte Leistungsanschlussklemme sind mit dem ersten Halbbrückenbereich, dem zweiten Halbbrückenbereich, dem ersten Halbbrücken-Leistungschip und dem zweiten Halbbrücken-Leistungschip verbunden, um damit einen Leistungskreis der Halbbrücken-Leistungsvorrichtung zu bilden. Der erste Halbbrücken-Leistungschip und der zweite Halbbrücken-Leistungschip sind jeweils mit dem ersten Halbbrückenabführbereich bzw. dem zweiten Halbbrückenabführbereich verbunden, um damit einen Signalregelkreis für die Halbbrücken-Leistungsvorrichtung zu bilden.

## Beschreibung

### Technisches Gebiet

Die vorliegende Patentanmeldung betrifft vor allem das Gebiet der Leistungselektronik, insbesondere eine Halbbrücken-Leistungsvorrichtung und ein Halbbrücken-Leistungsmodul.

### Stand der Technik

Halbbrücken-Leistungsvorrichtungen und Halbbrücken-Leistungsmodule werden häufig in einem elektrischen Gerät verwendet. Ein zu behandelndes Thema ist, wie die Einfachheit und die Funktionsstabilität der Produkte in der technischen Umsetzung, einschließlich der Produktion, Montage und Verwendung, verbessert werden kann, wenn elektrische Funktionen bei Anwendung der Halbbrücken-Leistungsvorrichtungen und der Halbbrücken-Leistungsmodulen realisiert werden. Insbesondere müssen die Probleme gelöst werden, wie die Streuinduktivität in der eigentlichen Schaltungsstruktur reduziert und wie die Stabilität der Struktur und die Einfachheit der Herstellung verbessert werden können.

Das durch die vorliegende Patentanmeldung zu lösende technische Problem besteht darin, eine Halbbrücken-Leistungsvorrichtung und ein Halbbrücken-Leistungsmodul bereitzustellen, um die Herstellung und die Verwendung der Halbbrücken-Leistungsvorrichtung und des Halbbrücken-Leistungsmoduls effizient, einfach und stabil zu verwirklichen.

Um das oben genannte technische Problem zu lösen, stellt die vorliegende Patentanmeldung eine Halbbrücken-Leistungsvorrichtung bereit, die dadurch gekennzeichnet ist, dass sie umfasst:
ein Modulsubstrat, dessen obere Oberfläche diskret einen ersten Halbbrückenbereich, einen zweiten Halbbrückenbereich, einen ersten Halbbrückenabführbereich und einen zweiten Halbbrückenabführbereich umfasst, wobei sich der erste Halbbrückenabführbereich und der zweite Halbbrückenabführbereich jeweils an beiden Enden des Modulsubstrats befinden;
Halbbrücken-Leistungschips, die einen ersten Halbbrücken-Leistungschip und einen zweiten Halbbrücken-Leistungschip umfassen, wobei der erste Halbbrücken-Leistungschip und der zweite Halbbrücken-Leistungschip jeweils an dem ersten Halbbrückenbereich und dem zweiten Halbbrückenbereich anliegen;
Leistungsanschlussklemmen, die eine erste Leistungsanschlussklemme, eine zweite Leistungsanschlussklemme und eine dritte Leistungsanschlussklemme umfassen; wobei die erste Leistungsanschlussklemme, die zweite Leistungsanschlussklemme und die dritte Leistungsanschlussklemme mit dem ersten Halbbrückenbereich, dem zweiten Halbbrückenbereich, dem ersten Halbbrücken-Leistungschip und dem zweiten Halbbrücken-Leistungschip verbunden sind, um damit einen Leistungskreis der Halbbrücken-Leistungsvorrichtung zu bilden; wobei
ein erstes Ende der ersten Leistungsanschlussklemme über eine positive Stromschiene mit einem Pluspol des Gleichstroms verbunden ist und sich über ein erstes Ende des Modulsubstrats hinaus erstreckt, und ein zweites Ende der dritten Leistungsanschlussklemme mit einem Minuspol des Gleichstroms verbunden ist und sich über das erste Ende des Modulsubstrats hinaus erstreckt; und wobei sich die positive Stromschiene oberhalb der dritten Leistungsanschlussklemme befindet und ein zweites Ende der positiven Stromschiene einen ersten Höhenunterschied gegenüber dem zweiten Ende der dritten Leistungsanschlussklemme aufweist.

In einem Ausführungsbeispiel der vorliegenden Patentanmeldung ist vorgesehen, dass
ein zweites Ende der ersten Leistungsanschlussklemme mit dem ersten Halbbrückenleistungsbereich und mit einer Drain-Elektrode des ersten Halbbrücken-Leistungschips verbunden ist; und dass
ein erstes Ende der zweiten Leistungsanschlussklemme mit einer Source-Elektrode des ersten Halbbrücken-Leistungschips verbunden ist, ein zweites Ende der zweiten Leistungsanschlussklemme als Wechselstromausgang der Halbbrücken-Leistungsvorrichtung funktioniert, und ein drittes Ende der zweiten Leistungsanschlussklemme mit dem zweiten Halbbrückenbereich und mit einer Drain-Elektrode des zweiten Halbbrücken-Leistungschips verbunden ist, wobei sich das zweite Ende der zweiten Leistungsanschlussklemme über ein zweites Ende des Modulsubstrats hinaus erstreckt; und dass
ein erstes Ende der dritten Leistungsanschlussklemme mit einer Source-Elektrode des zweiten Halbbrücken-Leistungschips verbunden ist.

In einem Ausführungsbeispiel de vorliegenden Patentanmeldung ist vorgesehen, dass, wenn der erste Halbbrücken-Leistungschip mehrere erste Chips umfasst, das erste Ende der zweiten Leistungsanschlussklemme in mehrere Anschlüsse unterteilt ist, die jeweils mit den Source-Elektroden der mehreren ersten Chips verbunden sind; und dass sich eine Verbindungsstelle des zweiten Endes der ersten Leistungsanschlussklemme mit dem ersten Halbbrückenleistungsbereich in einem Bereich zwischen zwei der mehreren Anschlüsse befindet.

In einem Ausführungsbeispiel der vorliegenden Patentanmeldung ist vorgesehen, dass, wenn der zweite Halbbrücken-Leistungschip mehrere zweite Chips umfasst, das erste Ende der dritten Leistungsanschlussklemme in mehrere Anschlüsse unterteilt ist, die jeweils mit den Source-Elektroden der mehreren zweiten Chips verbunden sind.

In einem Ausführungsbeispiel der vorliegenden Patentanmeldung ist vorgesehen, dass für den Fall, dass der erste Halbbrücken-Leistungschip und der zweite Halbbrücken-Leistungschip jeweils mit dem ersten Halbbrückenabführbereich bzw. dem zweiten Halbbrückenabführbereich verbunden sind, gilt, dass
eine Gate-Elektrode des ersten Halbbrücken-Leistungschips mit dem ersten Halbbrückenabführbereich mittels Bonddraht verbunden ist, und eine Gate-Elektrode des zweiten Halbbrücken-Leistungschips mit dem zweiten Halbbrückenabführbereich mittels Bonddraht verbunden ist.

In einem Ausführungsbeispiel der vorliegenden Patentanmeldung ist vorgesehen, dass der erste Halbbrücken-Leistungschip und der zweite Halbbrücken-Leistungschip jeweils mit dem ersten Halbbrückenabführbereich bzw. dem zweiten Halbbrückenabführbereich verbunden sind, um damit einen Signalregelkreis für die Halbbrücken-Leistungsvorrichtung zu bilden.

In einem Ausführungsbeispiel der vorliegenden Patentanmeldung ist vorgesehen, dass für den Fall, dass die obere Oberfläche des Modulsubstrats diskret einen ersten Halbbrückenbereich, einen zweiten Halbbrückenbereich, einen ersten Halbbrückenabführbereich und einen zweiten Halbbrückenabführbereich umfasst, gilt, dass
die obere Oberfläche des Modulsubstrats eine Kupferbeschichtung umfasst, wobei die Kupferbeschichtung diskret einen ersten Halbbrückenbereich, einen zweiten Halbbrückenbereich, einen ersten Halbbrückenabführbereich und einen zweiten Halbbrückenabführbereich umfasst.

In einem Ausführungsbeispiel der vorliegenden Patentanmeldung ist vorgesehen, dass sich ein erstes Ende der ersten Leistungsanschlussklemme über eine positive Stromschiene über ein erstes Ende des Modulsubstrats hinaus erstreckt, und sich ein zweites Ende der zweiten Leistungsanschlussklemme über das zweite Ende des Modulsubstrats hinaus erstreckt, und sich ein zweites Ende der dritten Leistungsanschlussklemme über das erste Ende des Modulsubstrats hinaus erstreckt; und dass
sich die positive Stromschiene oberhalb der dritten Leistungsanschlussklemme befindet und ein zweites Ende der positiven Stromschiene einen ersten Höhenunterschied gegenüber dem zweiten Ende der dritten Leistungsanschlussklemme aufweist.

In einem Ausführungsbeispiel der vorliegenden Patentanmeldung ist vorgesehen, dass das zweite Ende der positiven Stromschiene eine erste Schweißstelle zum Verbinden mit einem dem Pluspol des Gleichstroms entsprechenden Leadframe durch Schweißverbindung aufweist; und dass ein erstes Ende der positiven Stromschiene und das erste Ende der ersten Leistungsanschlussklemme durch Schweißen miteinander verbunden werden; und dass
das zweite Ende der dritten Leistungsanschlussklemme eine zweite Schweißstelle zum Verbinden mit einem dem Minuspol des Gleichstroms entsprechenden Leadframe durch Schweißverbindung aufweist. das zweite Ende der zweiten Leistungsanschlussklemme eine dritte Schweißstelle zum Verbinden mit einem dem Wechselstromausgang entsprechenden Leadframe durch Schweißverbindung aufweist.

In einem Ausführungsbeispiel der vorliegenden Patentanmeldung ist vorgesehen, dass der Werkstoff der Leistungsanschlussklemme einen Kupferwerkstoff umfasst.

In einem Ausführungsbeispiel der vorliegenden Patentanmeldung ist vorgesehen, dass der Werkstoff des Modulsubstrats ein AMB-Keramiksubstrat oder ein DBC-Keramiksubstrat umfasst.

Die vorliegende Patentanmeldung stellt ferner ein Halbbrücken-Leistungsmodul bereit, das mehrere parallel geschaltete Halbbrücken-Leistungsvorrichtungen nach einem der obigen Beschreibungen umfasst.

Im Vergleich zum Stand der Technik hat die vorliegende Patentanmeldung folgende Vorteile. Bei der Halbbrücken-Leistungsvorrichtung gemäß den Ausgestaltungen der vorliegenden Anmeldung wird die Länge der Stromschiene verkürzt, die Induktivität des Stromkreises wird verringert, was die Leistungsdichte des Moduls verbessert und die Schwierigkeit bei der Anordnung des Halbbrücken-Leistungsmoduls reduziert. Die Ausgestaltungen der vorliegenden Anmeldung tragen ferner dazu bei, die interne Antriebskonsistenz der oberen und unteren Brücken auszugleichen. Gleichzeitig wird die Modulbreite nicht vergrößert, was für die Parallelschaltung von diskreten Halbbrücken-Leistungsvorrichtungen vorteilhaft ist. Zudem kann die Anzahl der laminierten Stromschienen reduziert werden, die Schwierigkeit der Montage und die Anzahl der Schweißstellen werden verringert, der Produktionstakt wird beschleunigt und die Herstellung- und Schweißqualität werden verbessert.

### Kurzbeschreibung der Figuren

Zum besseren Verständnis werden die Zeichnungen aufgezeichnet, die einen Teil der vorliegenden Anmeldung darstellen. Die Zeichnungen zeigen die Ausführungsbeispiele der vorliegenden Anmeldung, und erläutern zusammen mit der Beschreibung das Prinzip der vorliegenden Anmeldung. In den Figuren:
Fig. 1 ist eine schematische Strukturansicht einer Halbbrücken-Leistungsvorrichtung gemäß einem Ausführungsbeispiel der vorliegenden Anmeldung,
Fig. 2 ist eine schematische Strukturansicht der Halbbrücken-Leistungsvorrichtung gemäß einem Ausführungsbeispiel der vorliegenden Anmeldung,
Fig. 3 ist eine schematische Ansicht eines Aufbaus eines Halbbrücken-Leistungsmoduls gemäß einem Ausführungsbeispiel der vorliegenden Anmeldung,
Fig. 4 ist eine schematische Ansicht einer Halbbrücken-Leistungsmodulschaltung,
Fig. 5 ist eine schematische Strukturansicht einer Halbbrücken-Leistungsvorrichtung gemäß einem Ausführungsbeispiel der vorliegenden Anmeldung,
Fig. 6 ist eine schematische Strukturansicht einer Halbbrücken-Leistungsvorrichtung gemäß einem Ausführungsbeispiel der vorliegenden Anmeldung,
Fig. 7 ist eine schematische Strukturansicht eines Halbbrücken-Leistungsmoduls,
Fig. 8 ist eine schematische strukturelle Teilansicht einer Halbbrücken-Leistungsvorrichtung,
Fig. 9 ist eine schematische Strukturansicht einer Halbbrücken-Leistungsvorrichtung, und
Fig. 10 ist eine schematische Strukturansicht einer Halbbrücken-Leistungsvorrichtung.

### Ausführliche Ausführungsformen

Um die technischen Lösungen der Ausführungsbeispiele der Anmeldung näher zu erläutern, werden nachfolgend die Zeichnungen, die für die Beschreibung der Ausführungsbeispiele benötigt werden, kurz zusammengefasst. Selbstverständlich stellen die nachfolgenden Zeichnungen lediglich einige Beispiele oder Ausführungsbeispiele der Anmeldung dar, und nach diesen Zeichnungen kann der Fachmann ohne erfinderische Tätigkeit die Anmeldung ebenfalls für weitere ähnliche Szenarien anwenden. Wenn nicht anders angegeben oder vom Kontext anders verstanden, stehen die gleichen Bezugszeichen in den Figuren für die gleichen Strukturen oder Bedienungen.

Wie in der Anmeldung und in den Ansprüchen gezeigt, müssen sich die Begriffe "ein/eine/eines/einer" und/oder "der/das/die" nicht unbedingt auf die singuläre Form beziehen, sondern sie können auch die plurale Form enthalten, wenn im Kontext nicht deutlich anders angegeben. Allgemein umfassen die Begriffe "umfassen" und "enthalten" lediglich die deutlich angegebenen Schritte und Elemente, welche keine exklusive Auflistung darstellen, so dass das Verfahren oder die Einrichtung auch einen weiteren Schritt oder ein weiteres Element aufweisen kann.

Wenn nicht anders angegeben, sollen die relative Anordnung, die numerische Angabe und die Werte der in den Ausführungsbeispielen erläuterten Bauteile und Schritte den Umfang der Anmeldung nicht beschränken. Darüber hinaus ist zu verstehen, dass in den Figuren die einzelnen Teile nicht maßstäblich dargestellt sind, um die Beschreibung zu begünstigen. Die dem Fachmann bekannten Technologien, Verfahren und Vorrichtungen werden nicht detailliert diskutiert, aber sie sollen ggf. als ein Teil der Beschreibung angesehen werden. In allen hierbei dargestellten und diskutierten Beispielen soll ein konkreter Wert als beispielhaft, nicht beschränkend, konstruiert werden. Daher kann in einem anderen Beispiel des beispielhaften Ausführungsbeispiels ein anderer Wert angegeben werden. Es sollte darauf geachtet werden, dass in den Figuren die ähnliche Zahl und das ähnliche Zeichen die ähnlichen Gegenstände bedeuten, und dass ein Gegenstand nicht weiter diskutiert werden muss, wenn es bereits in einer vorherigen Figur definiert ist.

Es ist zu verstehen, dass im Rahmen der Beschreibung der Anmeldung die durch die positionellen Begriffe "vor", "hinter", "oben", "unten", "links", "rechts", sowie "seitlich", "longitudinal", "senkrecht", "horizontal", und "Oberseite", "Unterseite", usw. bezeichnete Richtung oder Positionierung jeweils in der Regel in Bezug auf die in der jeweiligen Abbildung dargestellten Richtung oder Positionierung verwendet wird, um lediglich die Anmeldung zu schildern und die Schilderung zu vereinfachen. Mit diesen positionellen Begriffen wird, wenn nicht anderes angegeben, weder implizit noch explizit auf die Positionierung sowie die Ausgestaltung und Bedienung der betreffenden Vorrichtung oder des betreffenden Elements in einer vorbestimmten Positionierung hingedeutet, so dass sie hier keine Beschränkung der Anmeldung darstellen. Die Richtungsbegriffe "innere", "äußere" bedeuten die Innenseite und Außenseite in Bezug auf das Profil eines Teils selbst.

Um die Beschreibung zu erleichtern, können hierin die Begriffe für ein relatives Raumverhältnis, wie "über", "oberhalb", "auf einer Oberseite", "auf", usw., zur Beschreibung des räumlichen positionellen Verhältnisses eines Mittels oder Merkmals zu einem anderen Mittel oder Merkmal in der Figur verwendet werden. Es ist zu verstehen, dass diese Begriffe für ein relatives Raumverhältnis neben der in der Figur dargestellten Position auch andere Positionen im Gebrauch oder im Betrieb einschließen sollen. Wenn beispielsweise das Mittel in der Figur umgekehrt angeordnet wird, wird ein vorher als "oberhalb eines anderen Mittels oder Bauteils" oder "über ein anderes Mittel oder Bauteil" beschriebenes Mittel nun als "unterhalb eines anderen Mittels oder Bauteils" oder "unter einem anderen Mittel oder Bauteil" positioniert. Damit kann der beispielhafte Begriff "oberhalb" die beide Positionen von "oberhalb" und "unterhalb" umfassen. Das Mittel kann natürlich auch auf andere Weise positioniert werden, wie z. B. um 90 Grad gedreht oder in einer noch anderen Position, und die hierin verwendete räumliche Beschreibung soll danach konstruiert werden.

Zudem sollte darauf hingewiesen, dass die Verwendung der Wörter "erste", "zweite", usw. nur zur Unterscheidung zwischen den jeweiligen Teilen dient, und diese Wörter keine besondere Bedeutung enthalten, wenn nicht anders angegeben. Daher sollen sie auch nicht als Beschränkung auf den Schutzumfang der Anmeldung verstanden werden. Obwohl die in der Anmeldung verwendeten Begriffe aus allgemein bekannten Begriffen ausgewählt wurden, erfolgt die Auswahl einiger Begriffe in der Beschreibung der Anmeldung anhand der Feststellung des Anmelders oder der Anmelderin und die konkrete Bedeutung ist aus entsprechenden Teilen der vorliegenden Anmeldung zu entnehmen. Des Weiteren soll die Anmeldung nicht nur anhand der verwendeten konkreten Begriffe, sondern auch mit Hilfe der Bedeutung einzelner Begriffe verstanden werden.

Es versteht sich, dass, wenn ein Teil "an einem anderen Teil angeordnet", "mit einem anderen Teil verbunden", "mit einem anderen Teil gekoppelt" oder "in Kontakt mit einem anderen Teil" ist, es direkt an dem anderen Teil angeordnet, mit dem anderen Teil verbunden oder gekoppelt oder in Kontakt sein kann oder alternativ dazu ein Einsteckteil vorhanden sein kann. Im Gegensatz dazu liegt kein Einsteckteil vor, wenn ein Teil "direkt an einem anderen Teil angeordnet", mit einem anderen Teil "direkt verbunden", "direkt gekoppelt" oder "direkt in Kontakt" ist. Zwischen einem ersten Teil und einem zweiten Teil liegt ebenfalls ein elektrischer Pfad, der einen Stromfluss gestattet, vor, wenn das erste Teil mit dem zweiten Teil "in elektrischem Kontakt" oder "elektrisch gekoppelt" ist. Der elektrische Pfad kann Kondensatoren, gekoppelte Induktoren und/oder andere Teile enthalten, die einen Stromfluss ermöglichen, selbst wenn kein direkter Kontakt zwischen den elektrisch leitfähigen Teilen besteht.

Gemäß den Ausführungsbeispielen der vorliegenden Anmeldung werden eine Halbbrücken (engl.: Half Bridge) -Leistungsvorrichtung und ein Halbbrücken-Leistungsmodul beschrieben.

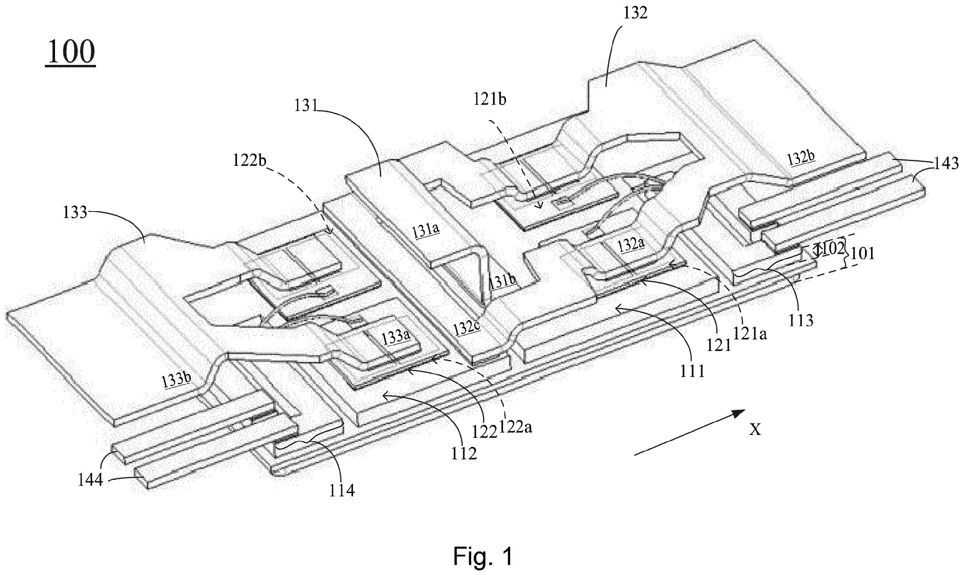

Fig. 1 ist eine schematische Strukturansicht einer Halbbrücken-Leistungsvorrichtung gemäß einem Ausführungsbeispiel der vorliegenden Anmeldung.

Unter Bezugnahme auf Fig. 1 umfasst die Halbbrücken-Leistungsvorrichtung 100 ein Modulsubstrat 101, Halbbrücken-Leistungschips und Leistungsanschlussklemmen.

In einigen Ausführungsbeispielen umfasst eine obere Oberfläche des Modulsubstrats 101 eine Kupferbeschichtung 102. Die Kupferbeschichtung 102 umfasst diskret einen ersten Halbbrückenbereich 111, einen zweiten Halbbrückenbereich 112, einen ersten Halbbrückenabführbereich 113 und einen zweiten Halbbrückenabführbereich 114. Der erste Halbbrückenabführbereich 113 und der zweite Halbbrückenabführbereich 114 befinden sich jeweils an beiden Enden des Modulsubstrats 101.

Die Halbbrücken-Leistungschips umfassen einen ersten Halbbrücken-Leistungschip 121 und einen zweiten Halbbrücken-Leistungschip 122. Der erste Halbbrücken-Leistungschip 121 und der zweite Halbbrücken-Leistungschip 122 liegen jeweils an dem ersten Halbbrückenbereich 111 und dem zweiten Halbbrückenbereich 112 an.

Die Leistungsanschlussklemmen umfassen eine erste Leistungsanschlussklemme 131, eine zweite Leistungsanschlussklemme 132 und eine dritte Leistungsanschlussklemme 133. Die erste Leistungsanschlussklemme 131, die zweite Leistungsanschlussklemme 132 und die dritte Leistungsanschlussklemme 133 sind mit dem ersten Halbbrückenbereich 111, dem zweiten Halbbrückenbereich 112, dem ersten Halbbrücken-Leistungschip 121 und dem zweiten Halbbrücken-Leistungschip 122 verbunden, um damit einen Leistungskreis der Halbbrücken-Leistungsvorrichtung 100 zu bilden.

Der erste Halbbrücken-Leistungschip 121 und der zweite Halbbrücken-Leistungschip 122 sind jeweils mit dem ersten Halbbrückenabführbereich 113 bzw. dem zweiten Halbbrückenabführbereich 114 verbunden, um damit einen Signalregelkreis für die Halbbrücken-Leistungsvorrichtung 100 zu bilden.

In einigen Ausführungsbeispielen ist vorgesehen, dass für den Fall, dass die erste Leistungsanschlussklemme 131, die zweite Leistungsanschlussklemme 132 und die dritte Leistungsanschlussklemme 133 mit dem ersten Halbbrückenbereich 111, dem zweiten Halbbrückenbereich 112, dem ersten Halbbrücken-Leistungschip 121 und dem zweiten Halbbrücken-Leistungschip 122 verbunden sind, um damit einen Leistungskreis der Halbbrücken-Leistungsvorrichtung 100 zu bilden, gilt, dass
ein erstes Ende 131a der ersten Leistungsanschlussklemme 131 mit einem Pluspol des Gleichstroms (DC+) verbunden ist; dass ein zweites Ende 131b der ersten Leistungsanschlussklemme 131 mit dem ersten Halbbrückenleistungsbereich 111 und mit einer Drain-Elektrode (engl.: drain) des ersten Halbbrücken-Leistungschips 121 verbunden ist, dass
ein erstes Ende 132a der zweiten Leistungsanschlussklemme 132 mit einer Source-Elektrode (engl.: source) des ersten Halbbrücken-Leistungschips 121 verbunden ist, ein zweites Ende 132b der zweiten Leistungsanschlussklemme 132 als Wechselstromausgang (AC-Ausgang) der Halbbrücken-Leistungsvorrichtung 100 funktioniert, und ein drittes Ende 132c der zweiten Leistungsanschlussklemme 132 mit dem zweiten Halbbrückenbereich 112 und mit einer Drain-Elektrode (engl.: drain) des zweiten Halbbrücken-Leistungschips 122 verbunden ist; und dass
ein erstes Ende 133a der dritten Leistungsanschlussklemme 133 mit einer Source-Elektrode (engl.: source) des zweiten Halbbrücken-Leistungschips 122 und ein zweites Ende 133b der dritten Leistungsanschlussklemme 133 mit einem Minuspol des Gleichstroms (DC-) verbunden ist.

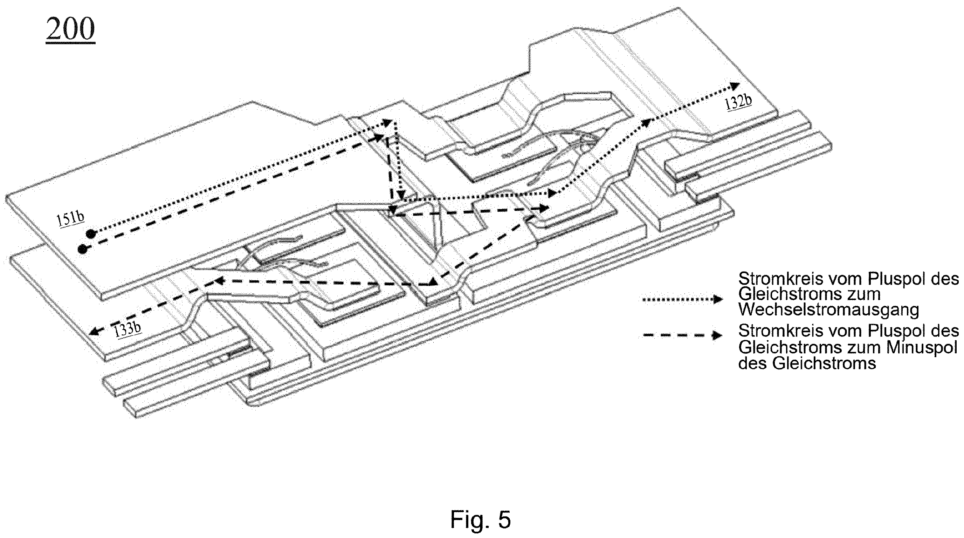

Fig. 5 ist eine schematische Strukturansicht einer Halbbrücken-Leistungsvorrichtung gemäß einem Ausführungsbeispiel der vorliegenden Anmeldung. Fig. 5 zeigt eine schematische Strömungsrichtung eines Stromkreises (engl.: current loop) der Halbbrücken-Leistungsvorrichtung 200, der vom Pluspol des Gleichstroms (DC+) zum Wechselstromausgang (AC-Ausgang) verläuft, und eine weitere schematische Strömungsrichtung eines Stromkreises der Halbbrücken-Leistungsvorrichtung 200, der vom Pluspol des Gleichstroms (DC+) zum Minuspol des Gleichstroms (DC-) verläuft, wobei insbesondere auf die Bezeichnungen durch die Legenden und die mit Pfeilen gekennzeichneten Linien in Fig. 5 verwiesen werden kann.

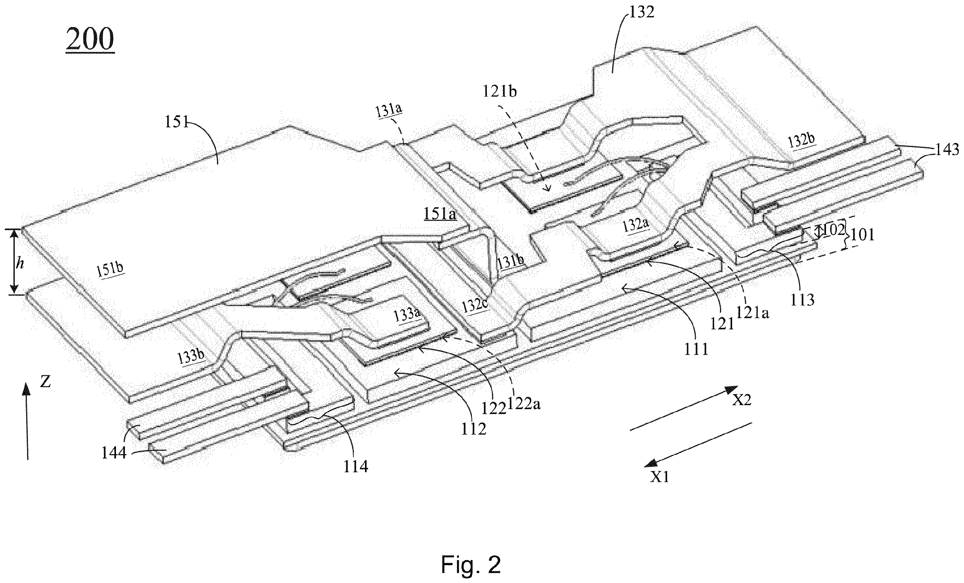

Fig. 2 ist eine schematische Strukturansicht der Halbbrücken-Leistungsvorrichtung gemäß einem Ausführungsbeispiel der vorliegenden Anmeldung.

Es wird auf Fig. 2 und 5 hingewiesen. Ein elektrisches Signal vom Pluspol des Gleichstroms (DC+) wird zuerst über eine positive Stromschiene 151 und die erste Leistungsanschlussklemme 131 mit dem ersten Halbbrückenbereich 111 und mit der Drain-Elektrode des ersten Halbbrücken-Leistungschips 121 verbunden. Danach wird die Source-Elektrode des ersten Halbbrücken-Leistungschips 121 durch das erste Ende 132a der zweiten Leistungsanschlussklemme 132 abgeführt und entlang eines Pfades zum zweiten Ende 132b der zweiten Leistungsanschlussklemme 132 als Wechselstromausgang (engl.: AC output) der Halbbrücken-Leistungsvorrichtung 200 übertragen, der auch als Wechselstrom-Phasenausgang (AC phase output) bezeichnet werden kann, wenn durch mehrere Halbbrücken-Leistungsvorrichtungen ein dreiphasiges Halbbrücken-Halbbrückenleistungsmodul gebildet wird.

Die Source-Elektrode des ersten Halbbrücken-Leistungschips 121 wird durch das erste Ende 132a der zweiten Leistungsanschlussklemme 132 abgeführt und entlang eines weiteren Pfades zum dritten Ende 132c der zweiten Leistungsanschlussklemme übertragen, mit dem zweiten Halbbrückenbereich 112 verbunden und somit mit einer Drain-Elektrode des zweiten Halbbrücken-Leistungschips 122 verbunden. Danach wird die Source-Elektrode des zweiten Halbbrücken-Leistungschips 122 durch das erste Ende 133a der dritten Leistungsanschlussklemme 133 abgeführt und zum zweiten Ende 133b der dritten Leistungsanschlussklemme 133 als elektrisches Signal für den Minuspol des Gleichstroms (DC-) der Halbbrücken-Leistungsvorrichtung 200 übertragen.

In einigen Ausführungsbeispielen ist vorgesehen, dass, wenn der erste Halbbrücken-Leistungschip 121 mehrere erste Chips umfasst, das erste Ende der zweiten Leistungsanschlussklemme in mehrere Anschlüsse unterteilt ist, die jeweils mit den Source-Elektroden der mehreren ersten Chips verbunden sind. Dabei befindet sich eine Verbindungsstelle des zweiten Endes der ersten Leistungsanschlussklemme 131 mit dem ersten Halbbrückenleistungsbereich 111 in einem Bereich zwischen zwei der mehreren Anschlüsse.

Wenn beispielsweise der erste Halbbrücken-Leistungschip 121 zwei erste Chips 121a, 121b umfasst, ist das erste Ende der zweiten Leistungsanschlussklemme in zwei Anschlüsse unterteilt, die jeweils mit den Source-Elektroden der mehreren ersten Chips 121a, 121b verbunden sind, wie in Fig. 1 gezeigt. Dabei befindet sich eine Verbindungsstelle des zweiten Endes der ersten Leistungsanschlussklemme 131 mit dem ersten Halbbrückenleistungsbereich 111 in einem Bereich zwischen zwei Anschlüssen.

In einigen Ausführungsbeispielen ist vorgesehen, dass, wenn der zweite Halbbrücken-Leistungschip 122 mehrere zweite Chips umfasst, das erste Ende der dritten Leistungsanschlussklemme 133 in mehrere Anschlüsse unterteilt ist, die jeweils mit den Source-Elektroden der mehreren zweiten Chips verbunden sind.

Wenn beispielsweise der zweite Halbbrücken-Leistungschip 122 zwei zweite Chips 122a, 122b umfasst, ist das erste Ende der dritten Leistungsanschlussklemme 133 in mehrere Anschlüsse unterteilt, die jeweils mit den Source-Elektroden der beiden zweiten Chips 122a, 122b verbunden sind, wie in Fig. 1 gezeigt.

In einigen Ausführungsbeispielen ist vorgesehen, dass für den Fall, dass der erste Halbbrücken-Leistungschip 121 und der zweite Halbbrücken-Leistungschip 122 jeweils mit dem ersten Halbbrückenabführbereich 113 bzw. dem zweiten Halbbrückenabführbereich 114 verbunden sind, gilt, dass
eine Gate-Elektrode (engl.: gate) des ersten Halbbrücken-Leistungschips 121 mit dem ersten Halbbrückenabführbereich 113 mittels Bonddraht (engl.: bonding line) verbunden ist, und eine Gate-Elektrode des zweiten Halbbrücken-Leistungschips 122 mit dem zweiten Halbbrückenabführbereich 114 mittels Bonddraht verbunden ist. Beispielsweise handelt es sich beim Bonddraht um einen Aluminiumdraht. Der erste Halbbrückenabführbereich 113 weist beispielsweise entsprechende Abführenden 143 auf, und der zweite Halbbrückenabführbereich 114 weist beispielsweise entsprechende Abführenden 144 auf.

Es wird auf Fig. 2 hingewiesen. In der Struktur der Halbbrücken-Leistungsvorrichtung 200 erstreckt sich das erste Ende 131a der ersten Leistungsanschlussklemme 131 über die positive Stromschiene 151 über ein erstes Ende des Modulsubstrats 101 hinaus und das zweite Ende 132b der zweiten Leistungsanschlussklemme 132 erstreckt sich über ein zweites Ende des Modulsubstrats 101 hinaus, beispielsweise in einer Erstreckungsrichtung einer ersten horizontalen Richtung X1. Das zweite Ende 133b der dritten Leistungsanschlussklemme 133 erstreckt sich über das erste Ende des Modulsubstrats 101 hinaus, beispielsweise in einer Erstreckungsrichtung einer zweiten horizontalen Richtung X2. Die positive Stromschiene 151 befindet sich oberhalb der dritten Leistungsanschlussklemme 133 und ein zweites Ende 151b der positiven Stromschiene 151 weist einen ersten Höhenunterschied h gegenüber dem zweiten Ende 133b der dritten Leistungsanschlussklemme 133 auf. Der erste Höhenunterschied h liegt z. B. in der vertikalen Richtung Z.

In einigen Ausführungsbeispielen ist vorgesehen, dass das zweite Ende 151b der positiven Stromschiene (engl.: busbar) 151 eine erste Schweißstelle zum Verbinden mit einem dem Pluspol des Gleichstroms (DC+) entsprechenden Leadframe durch Schweißverbindung aufweist. Ein erstes Ende 151a der positiven Stromschiene und das erste Ende 131a der ersten Leistungsanschlussklemme 131 werden durch Schweißen miteinander verbunden, wobei die spezifische Schweißposition als mittlere Schweißstelle bezeichnet werden kann.

Das zweite Ende 133b der dritten Leistungsanschlussklemme 133 weist eine zweite Schweißstelle zum Verbinden mit einem dem Minuspol des Gleichstroms (DC-) entsprechenden Leadframe durch Schweißverbindung auf. Das zweite Ende 133b der dritten Leistungsanschlussklemme 133 weist einen Erstreckungsabschnitt auf, der auch als negative Stromschiene (engl.: busbar) ausgebildet ist.

Das zweite Ende 132b der zweiten Leistungsanschlussklemme 132 weist eine dritte Schweißstelle zum Verbinden mit einem dem Wechselstromausgang (AC-Ausgang) entsprechenden Leadframe durch Schweißverbindung auf.

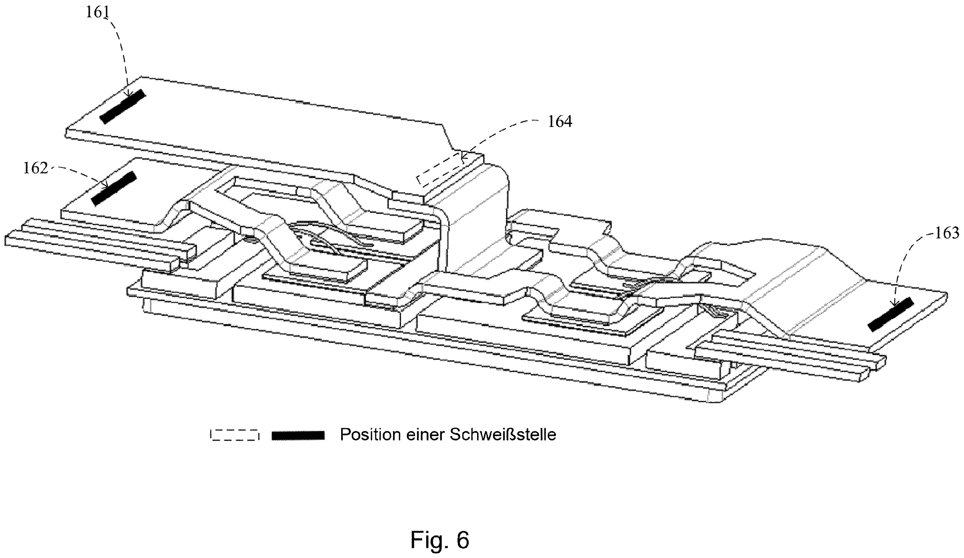

Fig. 6 ist eine schematische Strukturansicht einer Halbbrücken-Leistungsvorrichtung gemäß einem Ausführungsbeispiel der vorliegenden Anmeldung. In Fig. 6 sind eine Position 161, eine Position 162 und eine Position 163 dargestellt, in denen sich jeweils die erste Schweißstelle, die zweite Schweißstelle und die dritte Schweißstelle befinden. In Fig. 6 ist ferner eine Position 164 dargestellt, in der sich die mittlere Schweißstelle befindet. Wie vorstehend beschrieben, wird durch die mittlere Schweißstelle das zweite Ende der positiven Stromschiene 151 mit dem ersten Ende der ersten Leistungsanschlussklemme verschweißt, um eine elektrische Verbindung herzustellen. Der englische Begriff "laser welding seam" bezeichnet einen Bereich, in dem sich eine Laserschweißnaht befindet.

In einigen Ausführungsbeispielen umfasst der Werkstoff der Leistungsanschlussklemme einen Kupferwerkstoff. Der Werkstoff der positiven Stromschiene kann auch aus einem Kupferwerkstoff bestehen. Der Werkstoff des Modulsubstrats 101 umfasst ein AMB (engl.: Active Metal Brazing, Aktivmetallhartlöten) -Keramiksubstrat oder ein DBC (engl.: Direct Bonding Copper, Direktes Bonden von Kupfer) -Keramiksubstrat.

In der vorliegenden Anmeldung wird ferner ein Halbbrücken-Leistungsmodul bereitgestellt.

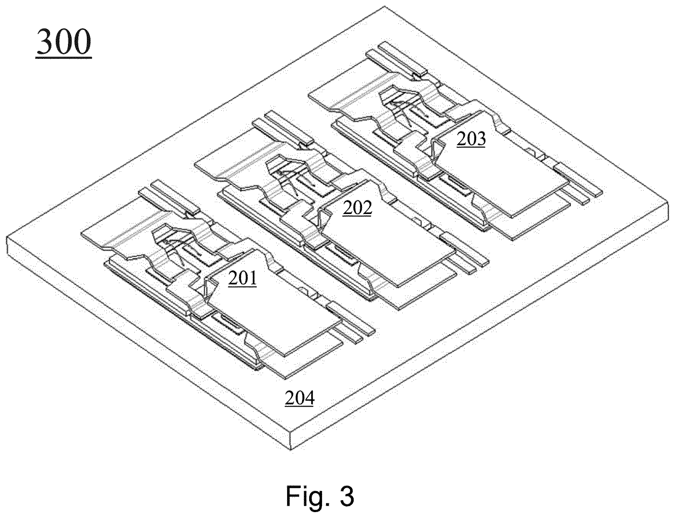

Fig. 3 ist eine schematische Ansicht eines Aufbaus eines Halbbrücken-Leistungsmoduls gemäß einem Ausführungsbeispiel der vorliegenden Anmeldung.

Unter Bezugnahme auf Fig. 2 umfasst ein Halbbrücken-Leistungsmodul 300 mehrere parallel geschaltete Halbbrücken-Leistungsvorrichtungen. Insbesondere umfasst es beispielsweise eine Halbbrücken-Leistungsvorrichtung 201, eine Halbbrücken-Leistungsvorrichtung 202 und eine Halbbrücken-Leistungsvorrichtung 203. Die Halbbrücken-Leistungsvorrichtung 201, die Halbbrücken-Leistungsvorrichtung 202 und die Halbbrücken-Leistungsvorrichtung 203 sind beispielsweise an einer Wärmeableitplatte oder einer Leiterplatte 204 angebracht. Der spezifische Aufbau einer Halbbrücken-Leistungsvorrichtung ist z. B. wie oben beschrieben.

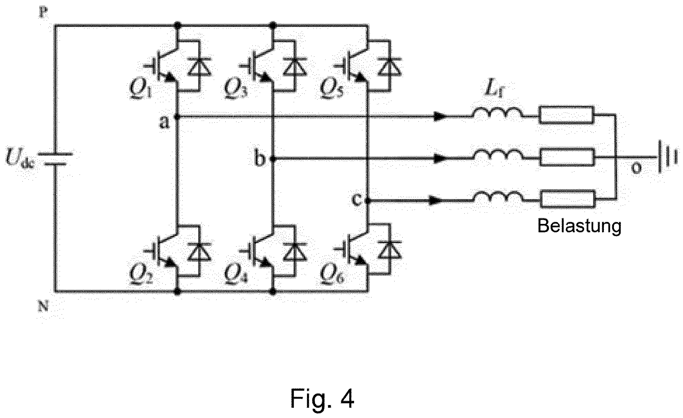

Fig. 4 ist eine schematische Ansicht einer Halbbrücken-Leistungsmodulschaltung, die insbesondere auch als dreiphasige Halbbrücken-Halbbrückenleistungsmodulschaltung bezeichnet werden kann.

In der Halbbrücken-Leistungsvorrichtung gemäß der vorliegenden Anmeldung entspricht der erste Halbbrücken-Leistungschip z. B. einem in Fig. 4 gezeigten ersten Leistungstransistor Q1 und der zweite Halbbrücken-Leistungschip entspricht z. B. einem in Fig. 4 gezeigten zweiten Leistungstransistor Q2. In Fig. 4 kann ein Zweig, in dem sich der erste Leistungstransistor Q1 befindet, als oberer Brückenzweig und ein Zweig, in dem sich der zweite Leistungstransistor Q2 befindet, als unterer Brückenzweig bezeichnet werden. Bei der in Fig. 1 oder 2 gezeigten Halbbrücken-Leistungsvorrichtung gemäß der vorliegenden Anmeldung kann der erste Halbbrücken-Leistungschip auch als oberer Brückenleistungschip bezeichnet werden, der zweite Halbbrücken-Leistungschip kann auch als unterer Brückenleistungschip bezeichnet werden, und der erste Halbbrückenbereich kann auch als oberer Brückenbereich bezeichnet werden und der zweite Halbbrückenbereich kann auch als unterer Brückenbereich bezeichnet werden. Dementsprechend verbinden die erste Leistungsanschlussklemme, die zweite Leistungsanschlussklemme und die dritte Leistungsanschlussklemme den oberen Brückenleistungschip (der sich in dem oberen Brückenbereich befindet) mit dem unteren Brückenbereich (der sich in dem unteren Brückenbereich befindet), um damit einen Leistungskreis der Halbbrücken-Leistungsvorrichtung zu bilden. Die Struktur der Leistungstransistoren in Fig. 4 ist nur schematisch und beschränkt nicht die spezifischen Typen von Leistungstransistoren. Dabei entsprechen verschiedene Typen von Leistungstransistoren verschiedenen Halbbrücken-Leistungschips.

Die drei Halbbrücken-Leistungsvorrichtungen 201, 202 und 203 aus Fig. 3 können z. B. parallel geschaltet werden, um dadurch ein dreiphasiges Halbbrücken-Halbbrückenleistungsmodul zu bilden (Fig. 3 zeigt eigentlich ein Leistungsmodul eines dreiphasigen Halbbrücken-Halbbrückenleistungsmoduls, der Rest ist nicht gezeigt). In einer praktischen elektrischen Anwendung kann durch eine Parallelanordnung mehrerer Halbbrücken-Leistungsvorrichtungen eine Halbbrücken-Leistungsmodulschaltung mit höherer Leistung gebildet werden.

Um die technische Wirkung der technischen Lösung der vorliegenden Anmeldung deutlicher zu erläutern, folgt eine vergleichende Beschreibung in Verbindung mit dem Aufbau einer Halbbrücken-Leistungsvorrichtung.

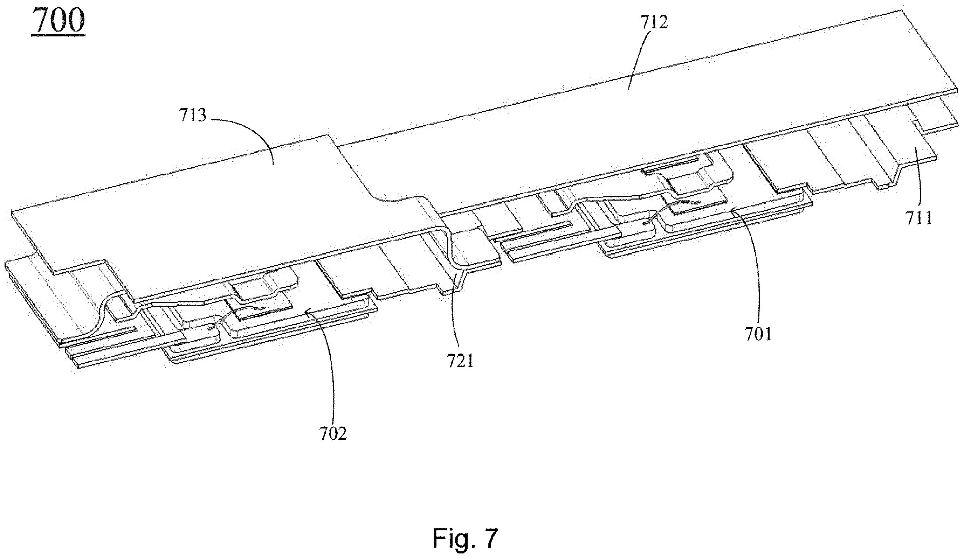

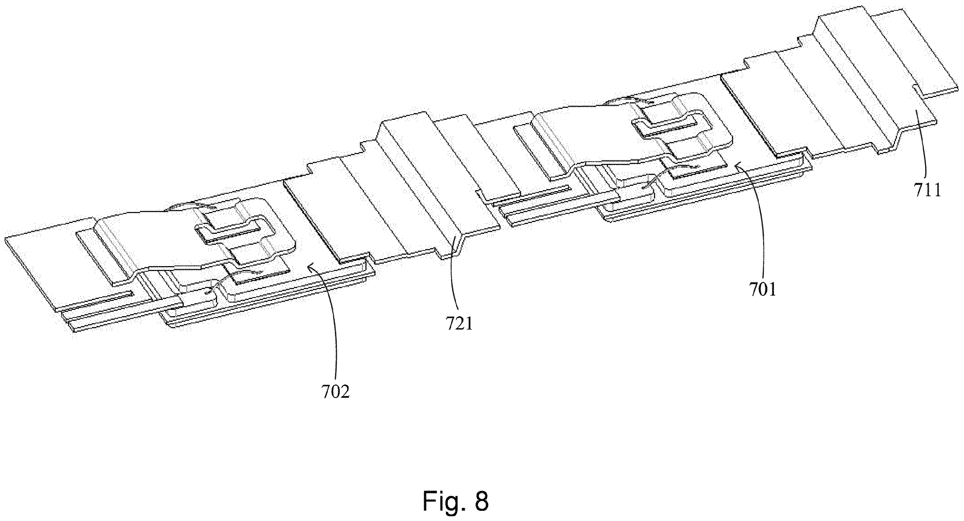

Fig. 7 ist eine schematische Strukturansicht eines Halbbrücken-Leistungsmoduls. Fig. 8 ist eine schematische strukturelle Teilansicht des Halbbrücken-Leistungsmoduls aus Fig. 7.

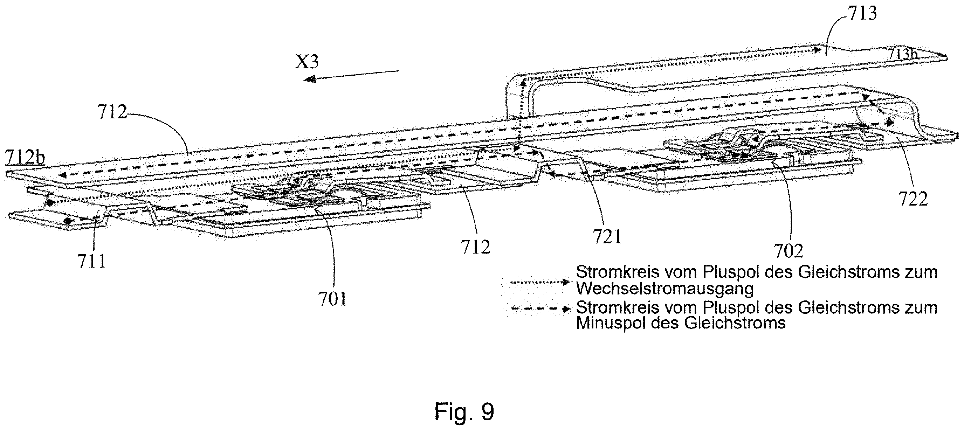

Fig. 9 ist eine schematische Strukturansicht des Halbbrücken-Leistungsmoduls aus Fig. 7 aus einer weiteren Perspektive.

Unter Bezugnahme auf Fig. 7 bis 9 umfasst ein Halbbrücken-Leistungsmodul 700 ein oberes Brückenmodul 701 und ein unteres Brückenmodul 702. Das Halbbrücken-Leistungsmodul wird aus dem oberen Brückenmodul 701 und dem unteren Brückenmodul 702 gebildet, indem die Anschlussklemmen miteinander verschweißt werden. Insbesondere werden beispielsweise eine Ausgangsanschlussklemme 712 des oberen Brückenmoduls 701 und eine Eingangsanschlussklemme 721 des unteren Brückenmoduls 702 miteinander verschweißt, um dadurch eine elektrische Verbindung herzustellen und somit das Halbbrücken-Leistungsmodul zu bilden. Die Verschweißung der Ausgangsanschlussklemme 712 des oberen Brückenmoduls 701 mit der Eingangsanschlussklemme 721 des unteren Brückenmoduls 702 ist entsprechend mit einer sechsten Schweißstelle versehen.

Fig. 9 zeigt ferner eine schematische Ansicht einer Stromkreisrichtung einer Halbbrücken-Leistungsvorrichtung. Mit Bezug auf Fig. 8 wird eine Eingangsanschlussklemme 711 des oberen Brückenmoduls 701 mit einem elektrischen Signal vom Pluspol des Gleichstroms (DC+) beaufschlagt, das durch das erste Halbbrückenmodul 701, das zweite Halbbrückenmodul 702 zu einer Ausgangsanschlussklemme 722 des zweiten Halbbrückenmoduls 702 und dann durch die Stromschiene 712 läuft, um damit einen Übertragungskreis zu bilden. Dabei wird das zweite Ende 712b der Stromschiene 712 als Anschluss für den Minuspol des Gleichstroms (DC-) verwendet. In diesem Fall erfordert die Stromschiene 712 eine längere Länge in einer horizontalen Richtung X3, um das obere Brückenmodul 701 und das untere Brückenmodul 702 zu überspannen. Das erste Ende der Stromschiene 712 wird zur elektrischen Verbindung mit der Ausgangsanschlussklemme 722 des zweiten Halbbrückenmoduls 702 verschweißt, so dass entsprechend eine siebte Schweißstelle vorhanden ist.

Die Eingangsanschlussklemme 721 des zweiten Halbbrückenmoduls 702 leitet auch ein Signal über die Stromschiene 713 ab und das zweite Ende 713b der Stromschiene 713 wird als Wechselstromausgang (AC-Ausgang) des Halbbrücken-Leistungsmoduls 700 verwendet. Die Stromschiene 713 wird durch Verschweißen mit der Eingangsanschlussklemme 721 des zweiten Halbbrückenmoduls 702 verbunden, so dass entsprechend eine achte Schweißstelle vorhanden ist.

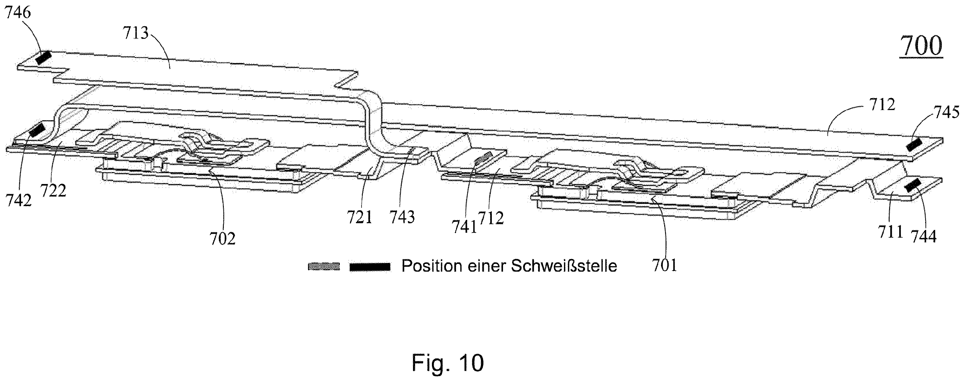

Fig. 10 ist eine schematische Strukturansicht der Halbbrücken-Leistungsvorrichtung aus Fig. 7 aus einer weiteren Perspektive. Beispielsweise ist die Position der sechsten Schweißstelle mit 741 in Fig. 10 bezeichnet. Beispielsweise ist die Position der siebten Schweißstelle mit 742 in Fig. 10 bezeichnet. Beispielsweise ist die Position der achten Schweißstelle mit 743 in Fig. 10 bezeichnet. Der Umfang der achten Schweißstelle wird teilweise von der Stromschiene 712 verdeckt.

Unter weiterer Bezugnahme auf Fig. 10 weist ein erstes Ende der Eingangsanschlussklemme 711 des oberen Brückenmoduls 701 des Halbbrücken-Leistungsmoduls 700 ferner eine neunte Schweißstelle 744 zum Verbinden mit einem dem Pluspol des Gleichstroms entsprechenden Leadframe durch Schweißverbindung auf. Das zweite Ende der Stromschiene 712 weist zudem eine zehnte Schweißstelle 745 zum Verbinden mit einem dem Minuspol des Gleichstroms entsprechenden Leadframe durch Verschweißen auf. Das zweite Ende der Stromschiene 713 weist zudem eine elfte Schweißstelle 746 zum Verbinden mit einem dem Wechselstromausgang entsprechenden Leadframe durch Verschweißen auf.

In einer in Fig. 7 bis 10 gezeigten Ausgestaltung einer Halbbrücken-Leistungsvorrichtung werden das obere Brückenmodul und das untere Brückenmodul in Reihe geschaltet werden, um damit eine Halbbrücken-Leistungsvorrichtung zu bilden, und die negative Stromschiene, die dem Minuspol des Gleichstroms entspricht, muss über einen längeren Pfad mit dem entsprechenden Leadframe verbunden werden, was zu einer größeren Streuinduktivität (engl.: stray inductance) führt, und die größere Länge der Stromschiene, die die obere Brücke mit der unteren Brücke verbindet, führt auch zu einer größeren Streuinduktivität. Da sich die DC+ und DC- Anschlüsse jeweils an den beiden Enden des Halbbrücken-Leistungsmoduls 700 befinden und sich der AC-Phasenausgang in der Mitte des Moduls 700 befindet, führt dies zu einer komplizierten Konstruktion der laminierten Stromschienen (engl.: laminated busbar), einer Schwierigkeit bei der Durchführung des Laserschweißverfahrens und einer großen Länge der laminierten Stromschiene. Bedingt durch die große Länge der Stromschiene (engl.: busbar) ist auch die Vibrationsfestigkeit geringer.

Demgegenüber werden bei den technischen Lösungen der vorliegenden Anmeldung, siehe Fig. 1 bis 2 und Fig. 5 bis 6, das obere und das untere Brückenmodul der Halbbrücken-Leistungsvorrichtung 200 gemeinsam, d.h. auf demselben Substrat, integriert, und durch eine Änderung des Pfads des Stromschienen-Leistungskreises wird die Länge der Verdrahtung verringert, was zu einer Verringerung der Streuinduktivität führt. Außerdem befinden sich nach der Änderung des Pfads des Stromschienen-Leistungskreises die DC+ und DC- Anschlüsse auf einer und derselben Seite der Halbbrücken-Leistungsvorrichtung 200, und der AC-Phasenausgang befindet sich auf der anderen Seite der Halbbrücken-Leistungsvorrichtung 200, wodurch ein Versatz zwischen den Stromschienen vermieden wird, die Konstruktionskomplexität der laminierten Stromschienen erheblich reduziert wird, der Montageprozess vereinfacht wird und das entsprechende Laserschweißverfahren einfach und leicht durchzuführen ist. Die DC+ und DC- Anschlüsse sind räumlich in Längsrichtung laminiert, so dass sich die durch den Strom erzeugten Magnetfelder gegenseitig aufheben, wodurch die parasitären Parameter der Vorrichtung verbessert werden.

Bei der Halbbrücken-Leistungsvorrichtung gemäß den Ausgestaltungen der vorliegenden Anmeldung wird die Länge der Stromschiene verkürzt, die Induktivität des Stromkreises wird verringert, so dass die Vds-Spitzenspannung und der Schaltverlust des Moduls verbessert werden. Gleichzeitig werden Volumen und Platz eingespart und es wird erlaubt, für Anwendungen mit höherer Leistung mehr Leistungsmodule parallel zu schalten. Nach der Formel Ls*d(Id)/dt = Vds (Ls stellt die Induktivität des Stromkreises dar) ist insbesondere die Vds-Spitzenspannung umso höher, je größer die Drain-Source-Induktivität der Halbbrücken-Leistungsvorrichtung ist. Zusätzlich dazu gilt für den Schaltverlust Esw = ∫(Vds*Id), d.h. der Schaltverlust Esw steigt mit der Erhöhung von Vds. Bei der Halbbrücken-Leistungsvorrichtung gemäß den Ausgestaltungen der vorliegenden Anmeldung werden daher die Verkürzung der Länge der Stromschiene und die Verringerung der Induktivität des Stromkreises verbessert, so dass die Spitzenspannung und der Schaltverlust der Halbbrücken-Leistungsvorrichtung erheblich verbessert werden.

Im Vergleich zur Ausgestaltung aus Fig. 7 bis 10 ist die Länge der Halbbrücken-Leistungsvorrichtung in der Ausgestaltung der vorliegenden Anmeldung um mindestens 1/3 reduziert, was die Leistungsdichte des Moduls verbessert und die Schwierigkeit bei der Anordnung des Halbbrücken-Leistungsmoduls reduziert. Die Klemmen für die Antriebssignale, d.h. die Anschlussklemmen für den Signalregelkreis, sind auf beiden Seiten des oberen und des unteren Brückenmoduls des Moduls verteilt, was dazu beiträgt, die interne Antriebskonsistenz der oberen und unteren Brücken auszugleichen. Gleichzeitig muss die Modulbreite nicht vergrößert werden, was für die Parallelschaltung von diskreten Halbbrücken-Leistungsvorrichtungen vorteilhaft ist. Zudem kann die Anzahl der laminierten Stromschienen reduziert werden, die Schwierigkeit der Montage und die Anzahl der Schweißstellen werden verringert, der Produktionstakt wird beschleunigt und die Schweißqualität wird verbessert. Durch die verkürzte Länge der Stromschiene wird auch die Vibrationsfestigkeit der Halbbrücken-Leistungsvorrichtung und damit des Halbbrücken-Leistungsmoduls erhöht.

Aus der Sicht des Verfahrensherstellungsprozesses ist ersichtlich, dass der für die Ausgestaltung der vorliegenden Anmeldung erforderliche Verfahrensablauf den Anforderungen des konventionellen Herstellungsprozesses entspricht und die Herstellbarkeit der Konstruktion erfüllt werden kann. Im Vergleich zu der in Fig. 7 bis 10 gezeigten Ausgestaltung wird die erforderliche Modulsubstratfläche verringert, die Kontaktfläche zwischen der Leistungsvorrichtung und der Wärmeableitplatte wird reduziert, so dass sich die Verbrauchsmenge einer Verbindungsschicht (gesintertes Silber oder Lotmaterial) dazwischen entsprechend verringert, was zu einer Kosteneinsparung führt. Gleichzeitig wird durch die Konstruktion der Halbbrücken-Leistungsvorrichtung die Schwierigkeit der Prozessfertigung reduziert, wodurch der UPH-Wert (unit per hour, Einheiten pro Stunde) der Verpackungs- und Testlinie erhöht wird.

Oben wurden die grundlegenden Konzepte beschrieben. Selbstverständlich dient die obige Offenbarung der Patentanmeldung dem Fachmann nur als Beispiel, ohne die Anmeldung zu beschränken. Obwohl es nicht deutlich angegeben wurde, kann ein Fachmann verschiedene Modifikationen, Verbesserungen und Änderungen an der Anmeldung vornehmen. Auf diese Modifikationen, Verbesserungen und Änderungen werden in der Anmeldung hingewiesen, so dass sie noch im Geist und Umfang der beispielhaften Ausführungsbeispiele der Anmeldung enthalten sein sollen.

Die vorliegende Anmeldung verwendet auch spezifische Wörter, um die Ausführungsbeispiele der Anmeldung zu beschreiben. Die Ausdrücke "eine Ausführungsform", "ein Ausführungsbeispiel" und/oder "einige Ausführungsbeispiele" stehen für ein Merkmal, eine Struktur oder eine Besonderheit, das/die mindestens einem Ausführungsbeispiel der vorliegenden Anmeldung zugeordnet ist. Deswegen sollte es betont und angemerkt werden, dass "eine Ausführungsform", "ein Ausführungsbeispiel" und/oder "ein alternatives Ausführungsbeispiel", das bzw. die in unterschiedlichen Absätzen der Beschreibung erwähnt ist bzw. sind, nicht zwangsläufig dieselbe Ausführungsform bzw. dasselbe Ausführungsbeispiel betreffen. Darüber hinaus können einige der Merkmale, Strukturen oder Besonderheiten eines oder mehrerer Ausführungsbeispiele der vorliegenden Anmeldung auf geeignete Weise miteinander kombiniert werden.

Analogisch sei darauf hingewiesen, dass in der vorstehenden Beschreibung der Ausführungsformen der vorliegenden Anmeldung verschiedene Merkmale manchmal in einem Ausführungsbeispiel, einer Figur oder Beschreibungen dazu eingeordnet werden, um die Beschreibung der Offenbarung der vorliegenden Anmeldung zu vereinfachen und das Verständnis einer oder mehrerer Ausführungsformen der Patentanmeldung zu erleichtern. Diese Offenbarung bedeutet jedoch nicht, dass die Merkmale des Gegenstands der vorliegenden Anmeldung mehr sind als die in den Ansprüchen genannten. Eigentlich sind die Merkmale der Ausführungsbeispiele weniger als alle Merkmale eines der oben offenbarten einzelnen Ausführungsbeispiele.

Obwohl die vorliegende Anmeldung unter Bezugnahme auf die vorliegenden spezifischen Ausführungsbeispiele beschrieben wurde, sollte der Durchschnittsfachmann jedoch erkennen, dass die vorstehend beschriebenen Ausführungsbeispiele nur der Veranschaulichung der vorliegenden Anmeldung dienen, wobei verschiedene äquivalente Änderungen oder Ersetzungen vorgenommen werden können, ohne vom Geist der vorliegenden Anmeldung abzuweichen. Daher fallen alle Änderungen bzw. Variationen an den vorstehend beschriebenen Ausführungsbeispielen in den Schutzumfang der Ansprüche der vorliegenden Anmeldung, solange sie im Rahmen des Geistes der vorliegenden Erfindung vorgenommen sind.

## Patentansprüche

1. Halbbrücken-Leistungsvorrichtung, **dadurch gekennzeichnet, dass** sie umfasst:
ein Modulsubstrat, dessen obere Oberfläche diskret einen ersten Halbbrückenbereich, einen zweiten Halbbrückenbereich, einen ersten Halbbrückenabführbereich und einen zweiten Halbbrückenabführbereich umfasst, wobei sich der erste Halbbrückenabführbereich und der zweite Halbbrückenabführbereich jeweils an beiden Enden des Modulsubstrats befinden;
Halbbrücken-Leistungschips, die einen ersten Halbbrücken-Leistungschip und einen zweiten Halbbrücken-Leistungschip umfassen, wobei der erste Halbbrücken-Leistungschip und der zweite Halbbrücken-Leistungschip jeweils an dem ersten Halbbrückenbereich und dem zweiten Halbbrückenbereich anliegen;
Leistungsanschlussklemmen, die eine erste Leistungsanschlussklemme, eine zweite Leistungsanschlussklemme und eine dritte Leistungsanschlussklemme umfassen; wobei die erste Leistungsanschlussklemme, die zweite Leistungsanschlussklemme und die dritte Leistungsanschlussklemme mit dem ersten Halbbrückenbereich, dem zweiten Halbbrückenbereich, dem ersten Halbbrücken-Leistungschip und dem zweiten Halbbrücken-Leistungschip verbunden sind, um damit einen Leistungskreis der Halbbrücken-Leistungsvorrichtung zu bilden; wobei
ein erstes Ende der ersten Leistungsanschlussklemme über eine positive Stromschiene mit einem Pluspol des Gleichstroms verbunden ist und sich über ein erstes Ende des Modulsubstrats hinaus erstreckt, und ein zweites Ende der dritten Leistungsanschlussklemme mit einem Minuspol des Gleichstroms verbunden ist und sich über das erste Ende des Modulsubstrats hinaus erstreckt; und wobei sich die positive Stromschiene oberhalb der dritten Leistungsanschlussklemme befindet und ein zweites Ende der positiven Stromschiene einen ersten Höhenunterschied gegenüber dem zweiten Ende der dritten Leistungsanschlussklemme aufweist.

2. Halbbrücken-Leistungsvorrichtung nach Anspruch 1, **dadurch gekennzeichnet, dass**
ein zweites Ende der ersten Leistungsanschlussklemme mit dem ersten Halbbrückenleistungsbereich und mit einer Drain-Elektrode des ersten Halbbrücken-Leistungschips verbunden ist; und dass
ein erstes Ende der zweiten Leistungsanschlussklemme mit einer Source-Elektrode des ersten Halbbrücken-Leistungschips verbunden ist, ein zweites Ende der zweiten Leistungsanschlussklemme als Wechselstromausgang der Halbbrücken-Leistungsvorrichtung funktioniert, und ein drittes Ende der zweiten Leistungsanschlussklemme mit dem zweiten Halbbrückenbereich und mit einer Drain-Elektrode des zweiten Halbbrücken-Leistungschips verbunden ist, wobei sich das zweite Ende der zweiten Leistungsanschlussklemme über ein zweites Ende des Modulsubstrats hinaus erstreckt; und dass
ein erstes Ende der dritten Leistungsanschlussklemme mit einer Source-Elektrode des zweiten Halbbrücken-Leistungschips verbunden ist.

3. Halbbrücken-Leistungsvorrichtung nach Anspruch 2, **dadurch gekennzeichnet, dass**, wenn der erste Halbbrücken-Leistungschip mehrere erste Chips umfasst, das erste Ende der zweiten Leistungsanschlussklemme in mehrere Anschlüsse unterteilt ist, die jeweils mit den Source-Elektroden der mehreren ersten Chips verbunden sind; und dass sich eine Verbindungsstelle des zweiten Endes der ersten Leistungsanschlussklemme mit dem ersten Halbbrückenleistungsbereich in einem Bereich zwischen zwei der mehreren Anschlüsse befindet.

4. Halbbrücken-Leistungsvorrichtung nach Anspruch 2, **dadurch gekennzeichnet, dass**, wenn der zweite Halbbrücken-Leistungschip mehrere zweite Chips umfasst, das erste Ende der dritten Leistungsanschlussklemme in mehrere Anschlüsse unterteilt ist, die jeweils mit den Source-Elektroden der mehreren zweiten Chips verbunden sind.

5. Halbbrücken-Leistungsvorrichtung nach Anspruch 1, **dadurch gekennzeichnet, dass** für den Fall, dass der erste Halbbrücken-Leistungschip und der zweite Halbbrücken-Leistungschip jeweils mit dem ersten Halbbrückenabführbereich bzw. dem zweiten Halbbrückenabführbereich verbunden sind, gilt, dass
eine Gate-Elektrode des ersten Halbbrücken-Leistungschips mit dem ersten Halbbrückenabführbereich mittels Bonddraht verbunden ist, und eine Gate-Elektrode des zweiten Halbbrücken-Leistungschips mit dem zweiten Halbbrückenabführbereich mittels Bonddraht verbunden ist.

6. Halbbrücken-Leistungsvorrichtung nach Anspruch 1, **dadurch gekennzeichnet, dass** der erste Halbbrücken-Leistungschip und der zweite Halbbrücken-Leistungschip jeweils mit dem ersten Halbbrückenabführbereich bzw. dem zweiten Halbbrückenabführbereich verbunden sind, um damit einen Signalregelkreis für die Halbbrücken-Leistungsvorrichtung zu bilden.

7. Halbbrücken-Leistungsvorrichtung nach Anspruch 1, **dadurch gekennzeichnet, dass** für den Fall, dass die obere Oberfläche des Modulsubstrats diskret einen ersten Halbbrückenbereich, einen zweiten Halbbrückenbereich, einen ersten Halbbrückenabführbereich und einen zweiten Halbbrückenabführbereich umfasst, gilt, dass
die obere Oberfläche des Modulsubstrats eine Kupferbeschichtung umfasst, wobei die Kupferbeschichtung diskret einen ersten Halbbrückenbereich, einen zweiten Halbbrückenbereich, einen ersten Halbbrückenabführbereich und einen zweiten Halbbrückenabführbereich umfasst.

8. Halbbrücken-Leistungsvorrichtung nach Anspruch 1, **dadurch gekennzeichnet, dass** das zweite Ende der positiven Stromschiene eine erste Schweißstelle zum Verbinden mit einem dem Pluspol des Gleichstroms entsprechenden Leadframe durch Schweißverbindung aufweist; und dass ein erstes Ende der positiven Stromschiene und das erste Ende der ersten Leistungsanschlussklemme durch Schweißen miteinander verbunden werden; und dass
das zweite Ende der dritten Leistungsanschlussklemme eine zweite Schweißstelle zum Verbinden mit einem dem Minuspol des Gleichstroms entsprechenden Leadframe durch Schweißverbindung aufweist.

9. Halbbrücken-Leistungsvorrichtung nach Anspruch 1, **dadurch gekennzeichnet, dass** das zweite Ende der zweiten Leistungsanschlussklemme eine dritte Schweißstelle zum Verbinden mit einem dem Wechselstromausgang entsprechenden Leadframe durch Schweißverbindung aufweist.

10. Halbbrücken-Leistungsvorrichtung nach Anspruch 1, **dadurch gekennzeichnet, dass** der Werkstoff der Leistungsanschlussklemme einen Kupferwerkstoff umfasst.

11. Halbbrücken-Leistungsvorrichtung nach Anspruch 1, **dadurch gekennzeichnet, dass** der Werkstoff des Modulsubstrats ein AMB-Keramiksubstrat oder ein DBC-Keramiksubstrat umfasst.

12. Halbbrücken-Leistungsmodul, umfassend mehrere parallel geschaltete Halbbrücken-Leistungsvorrichtungen nach einem der Ansprüche 1 bis 11.
